# EUROPEAN PATENT SPECIFICATION

(11) **EP 2 883 252 B1**
(45) Date of publication and mention of the grant of the patent: **27.11.2019**
(21) Application number: 13762205.6
(22) Date of filing: 09.08.2013
(51) Int. Cl.: H01L 41/09, F16K 31/00, H01L 41/113, H02N 2/00, H02N 2/10

(54) **A PIEZO-ELECTRIC ACTUATOR AND APPLICATIONS THEREOF**
PIEZOELEKTRISCHER AKTOR UND ANWENDUNGEN DAVON
ACTIONNEUR PIÉZOÉLECTRIQUE ET SES APPLICATIONS

(30) Priority: 09.08.2012 GB 201214270
(43) Date of publication of application: 17.06.2015
(73) Proprietor: Wilson, Stephen Austin, Somerset BA2 9ET (GB)
(72) Inventor: Wilson, Stephen Austin, Somerset BA2 9ET (GB)
(74) Representative: Barker Brettell LLP
(86) International application number: PCT/GB2013/052142
(87) International publication number: WO 2014/023979

(56) References cited:
- EP-A1- 1 652 672
- EP-A2- 0 154 473
- EP-A2- 1 243 417
- WO-A1-2006/087408
- DE-A1- 3 608 550
- US-A- 4 383 195
- US-A- 4 893 048
- US-A- 5 089 740
- US-A1- 2006 066 179
- US-A1- 2011 248 605
- WILSON S A ET AL: "Pre-stressed piezoelectric bimorph micro-actuators based on machined 40Â Â[mu]m PZT thick films: batch scale fabrication and integration with MEMS;Pre-stressed piezoelectric bimorph micro-actuators based on machined 40 mu m PZT thick films: batch scale fabrication and integration with MEMS", SMART MATERIALS AND STRUCTURES, IOP PUBLISHING LTD., BRISTOL, GB, vol. 19, no. 9, 5 August 2010 (2010-08-05) , page 94001, XP020197501, ISSN: 0964-1726, DOI: 10.1088/0964-1726/19/9/094001

## Description

This invention relates to a novel form of a piezoelectric bending actuator, a novel composite bending actuator, a method of forming a piezo electric actuator and applications of the new forms of piezo-electric actuators.

Some materials are known to generate an electrical charge in response to the applied mechanical stress. When piezoelectric materials are deformed by application of an external force they generate a surface electrical charge. This is known as the direct piezoelectric effect and has been usefully exploited in the creation of electro-mechanical sensors and sometimes in energy scavenging systems, whereby external vibrations from the environment, for example, applied to the piezoelectric layer generate an electrical charge repeatedly; this can be used directly or stored for later use.

In a converse piezoelectric effect mechanical strain in the material is generated as the result of the application of an electric field. The dimensional change is dependent on the piezoelectric properties of the material, its size and shape and the direction of the electrical excitation in relation to the polarisation of the material.

It is known to use the piezoelectric effect in actuators whereby a cantilever arm is moveable on application of an electric field. Such actuators may be used, for example as a safety feature in door locking mechanisms, having the advantage that they draw no electrical power under normal conditions but they may be activated in an emergency, for example as part of an automatic fire alarm system, to release the lock. It is also known to provide stack multilayer actuators in which a number of blocks of piezoelectric material are stacked together such that the overall movement of the stack is a cumulative change in dimensions of the blocks of piezo electric material. Each block in the assembly must have an electrode on opposing faces and the blocks making up a total assembly must be bonded together to give the total assembly mechanical strength. An advantage of this technique is that thinner layers can be fully activated at lower applied voltages. A total movement generated on application of a given voltage is thus amplified.

When a piezoelectric layer is bonded to a passive shim and activated, the entire assembly is able to bend in one direction. In most cases one part of the assembly is anchored and provided there is no external mechanical constraint a free part is able to move. The extent of the movement is referred to as the 'displacement' and the external force that would need to be applied to prevent movement is known as the blocking force; this type of assembly is known as a unimorph. When two piezoelectric layers are bonded with one on each side of a passive shim and the two piezoelectric layers are activated individually then the entire assembly can be made to bend in two opposing directions. This type of assembly is known as a bimorph.

Piezoelectric actuators which generate a driving force using the converse piezoelectric effect otherwise known as the 'piezoelectric motor' effect are used in a variety of applications such as inkjet heads, micro-pumps and ultrasonic motors. Typically, individual piezoelectric elements have deposited on them one or more conductive layers which is connected to an electrical circuit and this is used to apply a voltage across the piezoelectric material. On activation the piezoelectric material changes its shape and this deformation is exploited as the basis of the generated driving force.

It is also known to use piezoelectric materials in motors. A large variety of motor types have been described. Some of these exploit one or more resonant modes of the piezoelectric component in association with some external mechanism. Inchworm motors rely on a sequence of extensions and contractions of piezoelectric elements at a very high frequency and may be used to move relative to a runner that passes through the motor. Inertial stepper motors rely similarly on very high frequency extensions and contractions of piezoelectric elements and they make contact with a moveable runner by friction.

Piezo electric motors are desirable in some situations. They can typically be controlled to high degree of accuracy, sub-micron resolution is achievable and they can deliver a high force with a fast response time. Piezoelectric motor systems often have a low part count as they have less need for gearboxes, brakes and clutches and they are sometimes simpler to control electronically.

Typically piezoelectric actuators develop some advantages over their more commonplace electromagnetic counterparts when sizes are reduced; power-density is higher, but perhaps most significantly, the increased difficulty of manufacture associated with very small electromagnetic motors typically motors in the sub 0.5 cm³ volume range can be largely avoided. Thus it is desirable to be able to produce highly compact piezoelectric actuators for use in applications where weight or size is of high importance and to enable new types of systems to be created.

The present inventor described a novel method of manufacturing actors in the earlier published paper Wilson, S.A. & Owens, S. & Jourdain, R. (2010) 'Pre-stressed piezoelectric bimorph micro-actuators based on machined 40 micron PZT thick films: batch scale production and integration with MEMS', Smart Materials and Structures 19 094001.

EP 1 652 672 describes an inkjet print head which utilises a cantilever actuator in each ink chamber to control ink to be ejected. A plurality of ink chambers is provided and a plurality of cantilever actuators are each installed in each of the plurality of ink chambers. The actuators have a fixed end and a deflectable end and may be made of a bimorph element..

US2011/0248605 describes a piezoelectric power generating apparatus comprising a frame body having an axis line, a moving member and a plurality of piezoelectric portions. The moving member is penetrated onto the frame body. Each of the piezoelectric portions comprises a first end and a second end. Each of the first ends is fixed at the frame body and each of the second ends is fixed to a moving member which is arranged to move back and forth along the axis line of the frame body.

US 5 089 740 discloses a displacement generating apparatus comprising a gate-shaped structure in which a plurality of bimorph type piezoelectric elements are employed. The gate-shaped apparatus has a high rigidity and a high resonance frequency and can produce a carrying force greater than that of the conventional counterpart.

US 2006/0066179 discloses a motor including resonator and a vibration source which can be a piezoelectric source. A drive shaft is coupled to the resonator via a linkage. The vibration source imparts a vibration along the resonator such that a lateral displacement of the resonator is focused at a location coupled to the linkage. The lateral displacement is coupled to the drive shaft to provide rotational motion of the drive shaft.

US 4 383 195 discloses a piezoelectric actuator which includes piezoelectric element; a snap action device for exerting a positive force in opposition to the piezoelectric element and having predetermined reaction force that must be overcome to cause the snap action. The piezoelectric actuator includes means for applying an electric field to the piezoelectric means to enable it to generate the opposing force and store energy in the snap action device to enable occurrence of the snap action.

DE3608550 discloses a piezoelectrically actuated valve with an elongate piezocrystal arrangement held at one end in a housing, the terminals of which can be connected to a source of electric power to actuate the valve. Opening into an interior space in the housing are at least three valve passages, at least one sealing element at the free end of the piezocrystal arrangement projecting between two valve seats, one of these being connected to a feed passage and the other to a drain passage. A working passage is connected to one of the two other valve passages in each of the two valve positions.

There is provided a method of fabricating a piezoelectric actor comprising:
assembling and bonding at least one planar outer layer of piezoelectric material to a planar reinforcement layer to form a laminar assembly while the reinforcement layer is in an expanded condition relative to the piezoelectric layer such that a lateral compressive stress develops in the at least one outer layer when the at least one outer layer and the reinforcement layer in the laminar assembly is at the same temperature;
forming an electrically conductive coating on an external surface of the at least one outer layer;
etching the electrically conductive coating to define a tongue portion in the plane of the coating and bonding the laminar assembly to a substrate to form a composite structure.

In a preferred method the composite structure is temporarily bonded to a flat plate. A laser beam may be utilised to shape the actor. The actor may comprise a complex shape. Preferably the laser beam is moved through a pre-defined pattern that is defined by a computer programmed sequential path.

According to the invention there is provided a composite piezoelectric actuator in accordance with claim 1 of the appended claims.

The composite piezoelectric actuator comprises at least a first and a second actuator each comprising a plurality of actors with a composite structure:
wherein each actor has at least a first planar outer layer of piezoelectric material bonded to a planar reinforcement layer, an electrically conductive outer coating on an external surface of the first planar outer layer defining a tongue portion in the plane of the coating and wherein each of the actors are connected to and extend from a support element.

Preferably a gap of from 1 to 1000 microns (1 micron = 1µm) or more preferably from 5 microns to 500 microns or more preferably from 10 microns to 250 microns may be left around the edge of the etched tongue in which there is no electrically conductive material. Such a non conductive band may be advantageous in preventing short circuits when a voltage is applied to the actor. In some embodiments the non conductive band may be provided on both sides of the piezoelectric material but in other embodiments the band may be on only one side of the piezoelectric material, such as either an outer face of the piezoelectric material or an inner face of the piezoelectric material. It will be appreciated that the band may be around the electrically conductive outer coating on the piezoelectric material.

Preferably access ports are formed in the actor to make contact with the centre electrode. Such access ports are often referred to in the art as "vias". Preferably the via facilitates communication with at least one reinforcement layer in the actuator. In addition it is preferred that ports are additionally formed in the actor to provide passageways for the ancillary components. The passageways in each actor are preferably linked so that channels through the actuator are provided. Such channels may be used by at least one ancillary component. Such components may comprise ancillary mechanical components, electrical components, tubes, pressurised tubes, fibre optics or structural components or may provide fluidic channels. Alternatively the passageways or ports may be provided for access for fibre optics or for the provision of an optical access route. Additionally it will be appreciated that electrical contact with an electrically conducting reinforcement layer can be achieved by means of the via.

It is also desirable that mechanical fixing points are also provided. These may be external to the actor or may be provided by the formation of ports in the actor.

The method allows individual actors to be shaped with a high degree of 2D design freedom; hence many different 2D shapes can be produced. By way of illustration the creation of plane spiral components and cantilevers is described in the aforementioned paper but the development of different specialised shapes that are appropriate to particular applications is important beyond the cantilevers that have been utilised in the past.

Furthermore in the described method the or each actor is formed as part of an actuator.

In some embodiments the actuator may comprise more than two actors. It may be desirable to provide an actuator comprising at least one actor having a unimorph structure and at least a second actor having a bimorph structure.

Preferably the actuators formed by the inventive method are much smaller than conventional piezoelectric actuators. Typically the actuators may have a length or diameter from 1 mm to 25 mm or more preferably from 2 mm to 15 mm or more preferably from 3 mm to 10 mm or more preferably from 4 mm to 7 mm.

Typically a thickness of a single actor or an actuator comprising an single actor is from 0.01 mm to 1.0 mm (10 to 1000 microns) or from 0.05 mm to 0.50 mm (50 to 500 microns) or more preferably from 0.050 mm to 0.5 mm (50 to 500 microns. Most preferably the thickness is from 0.075 to 0.2 mm (75 to 200 microns) or from 0.02 mm to 0.12 mm (20 to 120 microns) and in other embodiments from 0.06 mm to 0.12 mm (60 to 120 microns). In one preferred embodiment the thickness is about 0.12 mm and in one particularly preferred embodiment the thickness is 90 microns (0.09 mm).

A complex shaped actuator can be produced by the claimed method in which a number of moveable actors are each joined to a support element. In a preferred method the complex actuator comprises a number of moveable actors integral with a support element. Preferably there are two or more actors. In a more preferred embodiment a plurality of actors extend from the support element. In some embodiments the support element is linear while in other embodiments the support element may be arranged such that the actors extend radially from the support element. In some embodiments the support element may be central with the actors extending radially outwards from the central support element. In some embodiments the central support element may be solid or have a relatively small diameter whereas in other embodiments the central support element may be hollow or may be arranged to have a relatively large diameter. In other embodiments the support element may be peripheral and the actors may extend radially inwardly from the support element. It will be appreciated that the skilled man can envisage alternative arrangements.

In one preferred embodiment the support element is linear and the or each actor is arranged along and extends from the support element. In a preferred embodiment the actuator has a length of from 0.05 mm to 100 mm or preferably from 0.05 mm to 50 mm and more preferably from 1.0 mm to 40 mm and more preferably still from 15 mm to 25 mm.

In another preferred embodiment the actors are arranged around and extend radially from a central support element. Such an actuator may comprise two or more or optionally up to five or six actors or more actors arranged around a central support element. It is desirable that up to 10 actors are arranged around a central support element and more preferably up to 8 actors are arranged around the central support element. In a particularly preferred embodiment up to 6 actors are arranged around the central support element. In a preferred embodiment the actuator has a diameter of from 0.05 mm to 100 mm and more preferably from 0.2 mm to 50 mm and more preferably from 1.0 mm to 10 mm and most preferably from 2 mm to 6 mm. It will be appreciated that alternative arrangements of a support element and a number of actors can be envisaged by the skilled man.

The two or more actors are independently controllable. The two or more actors may be controlled to move together or may move in response to independent control inputs. At least the first actor may have a first function and at least a second actor may be arranged to have a second function.

In one actuator according to the invention one planar outer layer of piezoelectric material is bonded to the reinforcement layer such that the composite structure of the or each actor comprises a unimorph. In another method two planar outer layers are bonded to the reinforcement layer such that the composite structure comprises a bimorph. Preferably a first outer layer is bonded to a first side of the reinforcement layer and a second outer layer is bonded to a second, opposing, side of the reinforcement layer. In a preferred embodiment the first and the second outer layers each have a thickness that is substantially the same although it is envisaged that the thickness of the first outer layer and the second outer layer of piezoelectric material could be different.

In a preferred method the reinforcement layer and the or each outer layer are at a first temperature when the or each outer layer is bonded to the reinforcement layer. Preferably at the first temperature the reinforcement layer is more expanded than the or each outer layer. When the outer layer and the reinforcement layer are cooled to a second temperature a lateral compressive stress is generated in the outer layer as the reinforcement layer contracts more than the or each outer layer and the reinforcement and the outer layer are bonded together. When the composite structure comprises a bimorph a lateral stress is generated in each of the outer layers.

Preferably the reinforcement layer is electrically conducting. Preferably the reinforcement layer comprises a metallic shim. In a preferred embodiment the reinforcement layer acts as a common electrode in use. In some embodiments the reinforcement layer further comprises a structural element. Preferably the reinforcement layer comprises an electrically conductive material such as aluminium, titanium, stainless steel, beryllium , copper or a copper alloy. It will be appreciated that in some embodiments the reinforcement layer may not comprise a structural element. In addition in some embodiments the reinforcement layer may not comprise electrically conducting material and may not act as a common electrode. It is envisaged that if the reinforcement layer is not conductive a thin layer of material acting as an electrode may be provided on the layer of piezoelectric material.

Preferably when the composite structure of the actor comprises a first outer layer and a second outer layer both the first and second outer layers are etched to define tongues portions in the plane of the coating on the first and second outer layers. Preferably the tongue portions are aligned.

In one preferred method the laminar assembly is bonded to a substrate that has been shaped to form an actuator as a flexible tongue in the plane of the laminar assembly. The substrate may have been shaped by etching. Excess material of the substrate is preferably removed to shape the substrate.

In an alternative method the laminar assembly is bonded to the substrate and the composite structure is etched or otherwise shaped to remove material from the composite structure to form the actor as a flexible tongue in the plane of the laminar assembly.

Preferably the piezoelectric material is a piezoceramic material. The piezoceramic material may be lead zirconate titanate or other electro-active functional ceramics such as those based on the lead magnesium niobate, lead titanate solid solution system, lead niobate and its derivatives, bismuth ferrite and its derivatives, lead scandium tantalite and its derivatives, barium strontium titanate and its derivatives and their compositional variations.

Preferably the reinforcement layer comprises an electrically conductive material such as aluminium, titanium, stainless steel, beryllium, copper or copper alloy or optionally a conductive or non-conductive polymeric composite material.

Each planar outer layer of piezoelectric material typically has a variation in surface flatness of +/-0.02 to 0.2 µm per mm and a similar variation tolerance on parallelism between the layers. More preferably each planar outer layer of piezoelectric material has a variation in surface flatness of +/-0.05 to 0.15 µm per mm and more preferably from 0.075 to 0.1 µm per mm

Preferably the composite structure of the actor has a total thickness of the order of from 5 to 200 µm. More preferably the composite structure has a total thickness from 10 to 150 µm and more preferably from 20 to 120 µm. Particularly preferred ranges are from 6 to 150 microns or from 7 to 125 microns.

In carrying out a method described, each outer layer of piezoelectric material may additionally be provided with an inner coating of an electrically conductive material on an inner surface facing the intermediate reinforcement metallic layer. It will be appreciated that the inner coating of electrically conductive material may be provided with a band of non conductive material around a periphery of the actor. The band may be substantially the same as the band described in relation to the outer coating of non conductive material and may have similar dimensions. It will be appreciated that each actor can be provided with a band around the inner coating and the outer coating or only around one of the inner and the outer coating of electrically conductive material. It is envisaged that the provision of a band of non-conductive material around the inner coating but not the outer coating may be advantageous in that a voltage can be applied to the inner coating and not to the exposed face of the actor.

Preferably the electrically conductive coating is formed of chromium, gold, platinum, titanium, aluminium or their alloys. Alternative electrically conductive coatings may be used. Such coatings may be based on carbon or organic carbon derivatives.

Preferably the device may be arranged to apply a voltage across the piezoelectric material by providing an electrical connection to the electrically conductive coating and to the electrically conducting reinforcement layer.

Preferably the inner and outer surfaces of the or each layer of piezoelectric material are coated with a planarising layer prior to application of the coating of electrically conductive material, the purpose of this layer is to promote adhesion of the electrically conducting layer to the piezoelectric ceramic layer.

Preferably the or each piezoelectric layer or the intermediate reinforcement layer or both are provided with a coating of benzocyclobutene or similar adhesive material prior to bonding the or each outer layer to the reinforcement layer. Typically an adhesive coating from 0.1 to 10 µm, or more preferably from 0.5 to 7 µm or most preferably from 1 to 5.0 µm may be used.

Alternatively, another means of bonding may be applied such as eutectic, adhesive, direct fusion, thermo-compression. Other methods not listed here would be obvious to the man skilled in the art.

A piezoelectric actor is formed according to the described method.

An actuator according to the invention comprises a support element and two or more actors extending from the support element.

The actors may be symmetrical but it is envisaged that asymmetrical arrangements may be used in particular applications.

The actuator may have two, three, four or more actors extending from the support element.

The two or more actors are independently controllable. There may be a first actor having a first function and a second actor having a second function. The two or more actors may be controlled to move together or may move in response to independent control inputs. For example one or more actors may be arranged to respond to a voltage applied to apply a force while one or more other actors may be arranged to have a separate function such as controlling a switch or operating a clutch. The one or more actors may be arranged to have a first function while the one or more other actors may be arranged to have a second function. The one or more first actors may be part of a first actuator and the one or more other actors may also be part of the first actuator.

In one preferred embodiment the support element is linear and two or more actors are arranged along and extend from the support element.

In another preferred embodiment the actors are arranged around and extend radially from a central support element. Such an actuator may comprise two, three, four, five six, eight or ten actors arranged around a central support element. Alternative arrangements of a support element and a number of actors can be envisaged.

Each of the first and second actuators comprises a support element and two or more actors extending from the support element. The composite actuator may comprise two, three, four, five, ten, fifty or five hundred or more actuators. Desirably the number of actuators is from five to one hundred actuators and more desirably from ten to fifty actuators and more preferably from ten to twenty actuators. According to the invention at least a first actor of the first actuator and a first actor of the second actuator are connected to a first linkage arranged to transfer a force or a displacement from the first and second actuators when a voltage is applied to the respective first actors. In one embodiment each first actor connected to the first linkage is electrically linked in parallel such that each of the first actors can be driven synchronously from an electric signal such as a voltage applied to the respective first actors.

Each actor may be a unimorph or may be a bimorph.

Preferably each actor connected to the first linkage is arranged to move in a first direction when a voltage is applied to each actor. In one embodiment each of the first actors are connected to a first linkage. Respective second actors of the first and second actuators may be connected to a common second linkage. Alternatively the respective second actors of the first and second actuators may beconnected to the first linkage and may be arranged to move in the first direction with the first actors of the first and second actuators.

In a preferred embodiment the composite actuator may comprise two, three, four, five or more actuators stacked together. A force transferred by a linkage is in the order of a sum of a force generated by each individual actors connected to the linkage. Accordingly if two, three or four individual actors are connected to a linkage the force transferred by the linkage is two, three or four times the force that each individual actor can transfer. It will be appreciated that there may be some mechanical inefficiency such that the actual force applied is a less than the theoretical sum of the individual forces.

In another embodiment at least one second actor is connected to a second linkage. The second linkage may be arranged to transfer a force and/or displacement of the at least one second actor in a direction differing from the direction of displacement of the first linkage when a voltage is applied to the at least one second actor.

In the composite actuator there may be a first linkage moveable in a first direction on application of a voltage. The first linkage may be moved by the effect of a voltage applied to the first actor. The direction of displacement of the second linkage may be opposed to or may just differ from the direction of displacement of the first linkage. In some embodiments the first linkage may be arranged to drive a mechanical component in a first direction and the second linkage may be arranged to drive a second mechanical component in a second direction. The second direction may be a reverse direction of the first direction such that bidirectional rotation can be produced.

The first linkage is arranged to drive a mechanical component in a first direction and at least the second linkage may be arranged to operate a second mechanism such as a clutch or brake mechanism. The composite actuator may also be arranged to move a mechanism into frictional contact with a further actuator or composite actuator.

It will be appreciated that the actuator may comprise one, two, three, four or more linkages.

The skilled man will understand that this aspect of the invention may be utilised to design complex valves and motors once the concept of arranging the actors to move in different directions has been appreciated. In addition the skilled man will understand that the or each linkage may be used to amplify a force or a displacement generated by the first and second actors when a voltage is applied. Preferably a linkage amplifies a force generated by the respective actors connected to that linkage.
According to an aspect of the invention there is provided a device in accordance with claim 12 of the appended claims.
The device may comprise a motor comprising at least one actuator according to another aspect of the invention.
A composite actuator in accordance with the an aspect of the invention may be utilised in a piezoelectric motor system. Such a system may comprise one composite actuator or a multiplicity of composite actuators and conventional mechanical components. Typically such mechanical components may be passive. The composite actuators in the motor system may comprise first and second actors that are independently controllable

In a preferred embodiment the motor comprises a plurality of actuators. There may be two, three, four, five or more actuators forming a composite actuator in the motor. In one embodiment the motor may comprise twenty or more actuators in the composite actuator. It will be appreciated that significantly higher forces can be generated by increasing the number of actuators comprising the composite actuator.

An advantage of motors in accordance with the invention is that the forces applied are increased dramatically but a diameter of the motor is maintained. Accordingly relatively small diameter motor systems can be arranged to deliver higher power densities than previously possible.

A composite actuator in such a motor comprises a number of connected individual actuators and as described above typically the actuators may have a length or diameter from 1 mm to 25 mm or more preferably from 2 mm to 15 mm or more preferably from 3 mm to 10 mm or more preferably from 4 mm to 7 mm. Typically a thickness of the actor is from 0.01 mm to 1.0 mm or from 0.05 mm to 0.5 mm or more preferably from 0.075 mm to 0.5 mm. Most preferably the thickness is from 0.075 to 0.2 mm and in a preferred embodiment is about 0.12 mm. In a particularly preferred embodiment the thickness is 90 microns (0.09 mm). In a preferred embodiment the composite actuator may comprise from 2 to 5 or 6, 8, 10 or more actuators and the composite actuator may have a length from 0.5 mm to 50 mm or more preferably from 1.0 mm to 25 mm or from 1.0 mm to 10 mm and in some embodiments from 1 mm to 6 mm.

In some preferred embodiments the diameter may be from 1 mm to 100 mm.

The device may comprise a motor according to an aspect of the invention.

In a preferred embodiment the device comprises a surgical instrument.
In some embodiments the composite actuator may comprise at least one actor arranged to generate a force or movement in a first direction in response to a voltage applied to the actuator and at least one second actor arranged to sense an applied force. The generated force may be as a result of the converse piezoelectric effect. The force applied may be sensed using the direct piezoelectric effect.

In some embodiments of the invention at least one actor may be arranged to move to generate and electrical charge from the application of an external mechanical force. An electrical charge may be generated which may provide a signal to a sensing system. Alternatively the electrical charge may be supplied to an energy scavenging system or to an energy storage system.

The device may contain a composite actuator according to an aspect of the invention.

The device may be selected from the group comprising a motor, a surgical instrument, a drug delivery system, an articulated mechanical joint or a pneumatic or fluidic valve,

According to a further aspect of the invention there is provided a pneumatic or fluidic valve in accordance with claim 14 of the appended claims.

The pneumatic or fluidic valve may comprise an actuator in accordance with an aspect of the invention.
An actuator in accordance with the disclosed invention may be utilised in a motor, a surgical instrument, a drug delivery system, a robot, an articulated mechanical joint, a pneumatic or fluidic valve.

Desirably in some applications a pneumatic or fluidic valve comprising one or more actuators or composite actuators in accordance with an aspect of the invention may be arranged such that the first actor or the respective first actors control at least one fluidic channel, inlet or outlet in a linear valve array. In some embodiments the first actor or the first respective first actors are arranged to control at least a second fluidic channel, inlet or outlet in a linear valve array and optionally the valve array is selected from the group comprising linear, circular and curved arrays or bi-linear or tri-linear arrays, or a dual-in-line arrangement. In an embodiment comprising composite actuators a subset comprising at least one actuator or composite actuator may be arranged to control fluid flow through the linear array. The fluid flow may be modified by the actuators operating to control, reduce or increase or to prevent fluid flow through the valve or valve array. In some embodiments one actor or subset of actors may control an inlet to be open or closed and another actor or subset of actors may regulate flow through the inlet if the valve is open. In some embodiments the valve may be arranged to control a flow of fluid from a pressurised source. It may be desirable to control fluid flow from the pressurised source to a multiplicity of outlets. Alternatively it may be desirable to control flow from a multiplicity of inlets to an outlet or outlets and the fluid may be pressurised or non pressurised. In some embodiments an actor of the composite actuator may be arranged to control more than one opening whether the opening is an inlet or an outlet.

According to another aspect of the invention there is provided a use of a pneumatic or fluidic valve array to control the flow from at least one pressurised fluid source in accordance with claim 1 of the appended claims.

Optionally the valve array may be array may be linear or circular or curved. Other configurations may be utilised as envisaged by the skilled man.

The valve array may be arranged to control flow from a multiplicity of outlets. The flow may be from a multiplicity of outlets from two or more sources and each source may be at the same temperature and or pressure or may be at different temperatures and/or pressures. The fluids flowing from the or each source may be the same or different. The pressurised source of fluid may be used for applications such as impingement cooling, raindrop shielding, insect shielding, automotive aerodynamic flow control of air around a moving vehicle, thermal regulation systems, ventilations systems, air stream shaping systems or the heating or cooling of components such as vehicle components. The valve arrays may also be used in personal hygiene and in providing fragrance delivery systems and gaseous mixtures such as oxygen enriched air and for medical uses such as the delivery of therapies, drugs and contrast agents

In its essence the actuator concept has been created in response to ongoing needs for: i) in microsurgery, in minimally invasive surgery and in robotic surgical systems, compact motor units that are highly controllable and which have high torque and high mechanical power densities; ii) for in-body medical imaging and diagnostic systems, compact actuator units with high controllability that are able to function within the body, as part of a catheter system or as part of an autonomous or semi-autonomous or tethered robot system; iii) methods to improve the efficiency of wind turbines in particular their starting and stopping characteristics through active modification of their virtual aerodynamic profile in different weather conditions; iv) methods to improve the aerodynamic efficiency of automotive vehicles through active modification of their virtual aerodynamic profile in different weather conditions and for different speeds of travel; v) reduction in the component count and miniaturisation of components for several automotive vehicle applications, including interior and exterior styling; in-cabin heating, cooling, ventilation, atmospheric quality and fragrance delivery; vi) electronic and electrical systems thermal management; vi) highly compact drug and vapour delivery systems; vii) high torque and high power density motors with sizes less than 1 cm³ that are inherently non-magnetic.

It is desirable to be able to manufacture a variety of piezoelectric actuators. Such actuators have advantages over electromagnetic counterparts and it is desirable to be able to produce highly compact piezoelectric actuators for use in applications where weight or size is important. A significant advantage of the method disclosed is that the actors can be formed with much greater design freedom than has previously been possible. In addition actuators comprising a cluster of actors can be formed and the actuators linked to form a composite actuator.

The present invention enables the construction and assembly of compact actuator and motor systems. A multiplicity of individual piezoelectric bimorph or unimorph actuators, which are constructed and shaped using a combination of precision machining and standard micro-fabrication techniques such as photolithography, full wafer bonding and laser machining according to a procedure described in the published journal paper are connected to one or more linkages to form an actuator or motor that is compact, highly controllable and can deliver high torque and high mechanical power densities.

Actuators in accordance with an aspect of the invention may be incorporated into motor drive systems for surgical robotics; motor drive systems for robotic assistance systems; in articulating instrumentation for minimally invasive surgery; in endoscopic systems; in autonomous and semi-autonomous robot systems used in medical imaging and diagnosis; in heating, cooling and ventilation systems for automotive vehicles; in active aerodynamic flow control systems for wind-powered electricity generators; in active aerodynamic flow control systems for automotive vehicles; in active aerodynamic flow control for motorcycles and pedal cycles; in impingement cooling systems for electronic components; in impingement cooling systems for batteries used in electric vehicles; in thermal management systems for automotive vehicles; in interior and exterior styling for automotive vehicles; in comfort systems for automotive vehicles; in exterior de-icing systems for automotive vehicles; in therapeutic drug delivery systems; in fragrance delivery systems; in vapour delivery systems; in air-quality management systems; in compositional adjustment and thermal management of controlled atmospheres; in heat pump systems; in safety systems for pneumatic systems; in servo systems for pneumatic and fluidic flow control systems; in modular pneumatic and fluidic valve-array systems; in energy harvesting systems based on forced vibration of an electro-active generating component. An example of the application of such a device is in the manipulation of end-effectors in intravascular catheters for cardiac surgery and coronary imaging. A further example is in the coordinated movement and positioning of modular components in robotic arms and for the operation of their end-effectors. In a further example the actuators deform under electrical control to open and close valves in pneumatic or fluidic systems. The actuators described, however, have a much broader range of applications consistent with general purpose motor units, valve units and valve-array units. The skilled man would understand that actuators in accordance with the invention could be incorporated into compact, low profile valve arrays, typically having a thickness of 5 to 15 mm and that these arrays could be supplied with pressured fluids, preferably gases, through tubes that are a few millimetres in diameter. It will be appreciated that such systems would have reduced part counts and would occupy less space in comparison with existing systems so creating new possibilities for passenger comfort systems in terms of design and automotive styling.

The invention will now be described by way of example only with reference to the accompanying drawings in which:
**Figure 1** shows an actuator formed in accordance with the invention;
**Figure 1a** represents a lower structural support for an alternative actuator;
**Figure 1b** represents a lower laminar piezoelectric component of the actuator;
**Figure 1c** represents a metal reinforcement layer for the actuator;
**Figure 1d** shows an upper laminar piezoelectric component;
**Figure 1e** represents an upper anchorage for the device;
**Figure 2a** shows a cross section of a composite actuator in accordance with an aspect of the invention;
**Figure 2b** is a cross section of the composite actuator of Figure 2a when a voltage is applied;
**Figure 2c** is a cross section of an alternative embodiment of a composite actuator;
**Figure 3** is a plan view from above a composite actuator in accordance with an aspect of the invention;
**Figure 4** shows a bimorph actuator according to the present invention;
**Figure 5** is a cross section of a linear array incorporating an actuator in accordance with the invention;
**Figure 6** is a plan view of a linear valve array utilising an actuator in accordance with the invention;
**Figure 7** is a cross section of a valve array utilising an actuator in accordance with the invention;
**Figure 8** is a cross section of an alternative valve array;
**Figure 9A and 9B** are schematic illustrations of an embodiment of the invention used in a micromotor,
**Figures 10A, 10B and 10C** are schematic illustrations of embodiments of the invention used in controlling the flow of fluid through a number of valve arrays;
**Figure 11** is a schematic illustration of an alternative actuator having a circumferential support element, and
**Figures 12A and 12B** are schematic diagrams showing an alternative embodiment of a linear actuator.

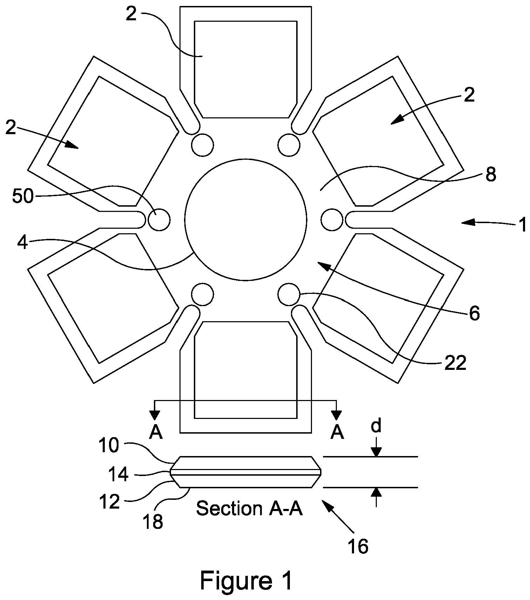

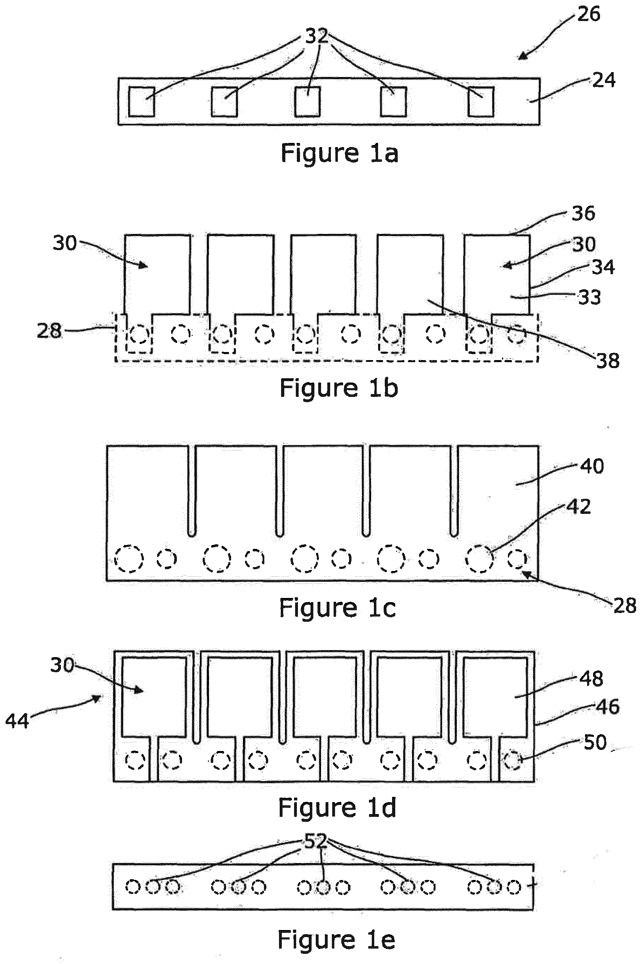

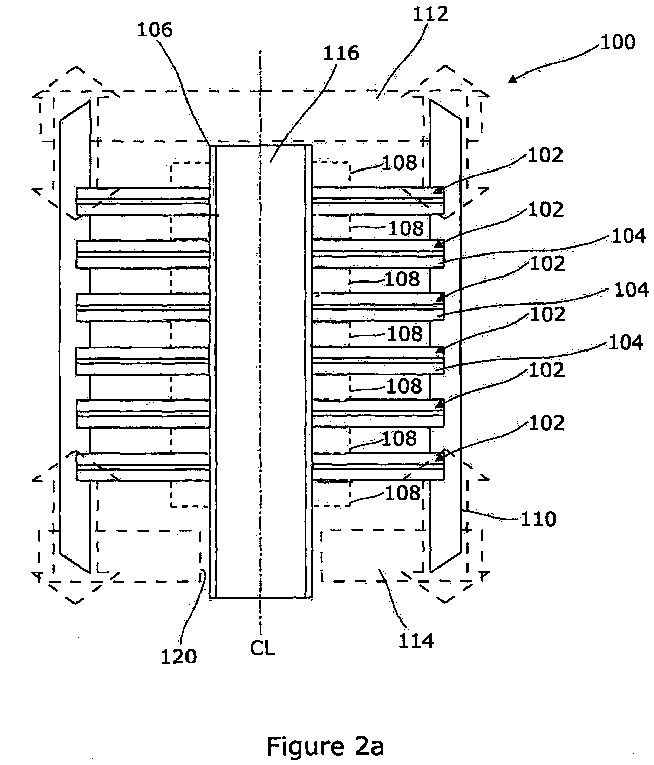

Figure 1 shows a piezoelectric actuator 1 comprising a bimorph device having six moveable actors 2 arranged symmetrically about a central opening 4. Each actor 2 is connected to a support element 6 in the form of a column 8 encircling the central opening 4. Each actor 2 is also arranged to be connected to a linkage as will be described and illustrated in relation to Figures 2a to 2c. In this embodiment the support element 6 is common to each of the six actors 2 arranged around the column.

Each actor 2 will now be described in more detail with reference to the section A-A in Figure 1. Each movable element forming an actor 2 comprises a first 10 and a second 12 outer layer of piezoelectric material and a planar reinforcement layer 14 bonded together to form a laminar assembly 16. Each outer layer 10, 12 has on its external surface a layer 18 of conductive material that has been etched to be patterned. The surface layer forms a surface electrode for the underlying electro-active material 10, 12. A gap of 50 microns may be left around the edge of the etched tongue of the actor in which there is no electrically conductive material. Such a gap may be advantageous in preventing short circuits when the actuator is in use and a voltage is applied to the actor.

The central planar reinforcement 14 provides mechanical strength and is also an electrically conductive layer, such that an electric field can be applied across the electro-active material 10, 12 between the electrically conducting outer layer 18 and the reinforcement layer 14.

Openings 22 are provided in the bimorph device 1 adjacent to the central column 8 or within the support element 6 and are used as conduits for electrical interconnections or optical connections or as a conduit for fluids or for open access or for through access.

It should be understood that alternative shaped actuators each with multiple moveable actors can be used as component parts of the invented actuator system described in more detail below.

An alternative linear actuator is illustrated in Figure 1a to 1e. Figure 1a shows a first structural support 24 for an alternative actuator 26 in accordance with the invention. In this embodiment the actuator 26 comprises a linear support element 28 and five actors 30 extending perpendicularly from the support element 28. The first structural support 24 is relatively rigid and is provided with electrical connections 32 that are arranged to connect with the electrical coatings on the individual actors 32.

Figure 1b is a representation of a first laminar piezoelectric ceramic assembly 34 forming part of the actuator. The first laminar assembly 34 is located adjacent the first structural support 24. The first laminar assembly 34 comprises a first (not shown) and a second 38 outer layer of conductive material. A first outer coating is arranged to be opposed to the first structural support and the first outer coating is patterned such that a portion of the first outer coating is in contact with the electrical connections 32 on the first structural support 24 when the actuator is assembled.

Figure 1c represents the metal shim 40 which is the planar reinforcement layer. Prior to assembly some of the metal material, represented by a hole 42, has been removed. It will be appreciated that the purpose of such holes 42 is to provide electrical isolation from the lower electrode pattern post-assembly.

Figure Id shows a second laminar piezoelectric ceramic assembly 44. On its external surface 46 it carries a coating of conductive material 48 that has been patterned. Holes 50 have been cut after assembly in order to provide electrical access to the metal shim 40 and separately to the first electrode assembly (not shown).

Figure 1e represents a second structural support for the device. The second structural support is distant from the first structural support 24. This second structural support does not prevent access to second electrodes, to the metal reinforcement layer 40 and to the first electrodes 32, as represented by the pattern of holes 52. It will be appreciated that this structural assembly permits the first electrode on each of the individual actors 30 to be contacted electrically independently of electrical contacts with other actors. Likewise the second electrode on each of the individual actors 30 can be electrically contacted independent of the others actors. The metal shim 40 may constitute a third electrode and in this eventuality it will be common to all of the individual actors.

Figure 2a shows a composite actuator construction 100 whereby multiple actuators comprising bimorph devices 102 each with multiple actors 104 are linked mechanically by a first linkage 110 in such a way that a mechanical force that can be generated by the composite actuator 100 is the sum of that generated by the individual bimorph actors 104. A mechanical column 106 connects the multiplicity of individual bimorph devices 102 and it provides a common anchor for them. The individual bimorph devices are separated by spacer elements 108 that are also fixed to the mechanical column 106.

The spacer elements 108 may also have a patterned surface coating of electrically conductive material that enables then to act as electrical interconnections to the first and second electrically conductive layers applied to the electro-active material present on the bimorph devices.

The composite actuator 100 comprising an assembly of bimorph devices 102 is further connected by a first moveable linkage 110 whose purpose is to transmit the combined force and displacement of the actors 104 when they are activated. The linkage 110 may link all of the actors 104 in the actuator assembly or it may be segmented, such that a first actor 104 or group of first actors connected to the first linkage 110 may be activated independently of a second group of actors. When the respective first actors in the bimorph devices 102 are activated they change their shape and linkage 110 is moved in relation to the fixed structure represented by the central column 106 which anchors the actors. As described above each of the bimorph device actuators comprises a support element which is located between the spacer elements 108 and the actors 104 extend from the support element.

A composite actuator as illustrated in Figure 2a may be incorporated into a motor for a surgical device in a manner that would be well understood by a man skilled in the art.

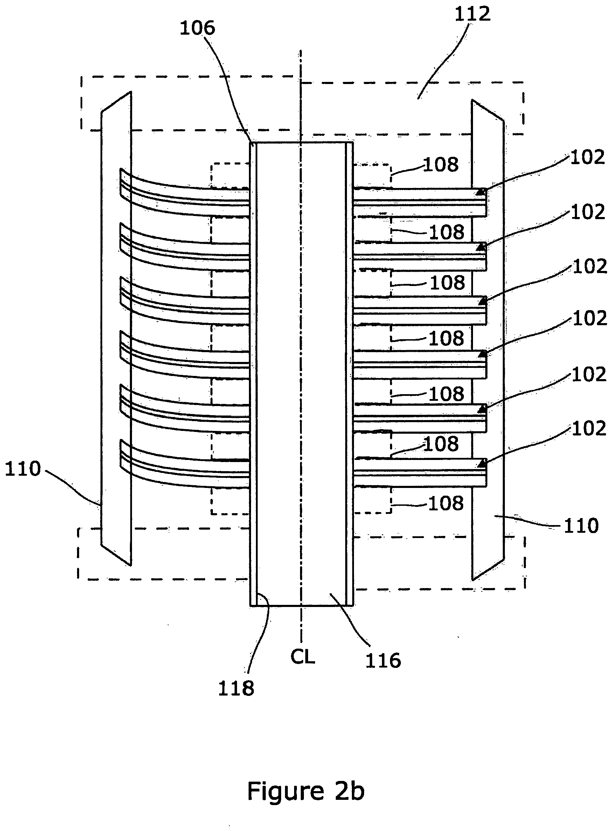

Figure 2b shows the relative movement, in an un-actuated state (right hand side of the diagram) and in an actuated state (left hand side of the diagram) (centre line - CL). In this way the multiple actors 104 are acting together to displace the linkage 110 and a force applied by the linkage is a combined force generated by each of the individual actors.

As shown in Figure 2a and 2b a further moveable component 112 connected to the linkage 110 can optionally be provided to facilitate transfer of the generated force to ancillary components. Ancillary components may include an elastic fin device such as that described in US Patent No: 6,664,712, Ultrasonic motor, whose purpose is the transpose the linear movement of the linkage 110 into rotary motion about a central axis. As shown in Figure 2b the moveable component 112 may be solid or in a variation 114 illustrated in Figure 2a may provide a conduit for mechanical or other systems components.

The anchorage 106 may also function as a tubular central shaft 116 containing concentric tubes that are capable of relative movement. Hence a central opening 118 may be used to support an ancillary rotating component such as an axle and it may also function as a conduit for electrical interconnections or optical connections or as a conduit for fluids or for open access or for through access. Likewise the openings in the actuator devices 102 may also function as a conduit for electrical interconnections or optical connections or as a conduit for fluids or for open access or for through access.

It should be understood that alternative and non-centro-symmetric configurations for the mechanical linkages 110 are consistent with the basic multiple multi-flexible-element actuator configuration.

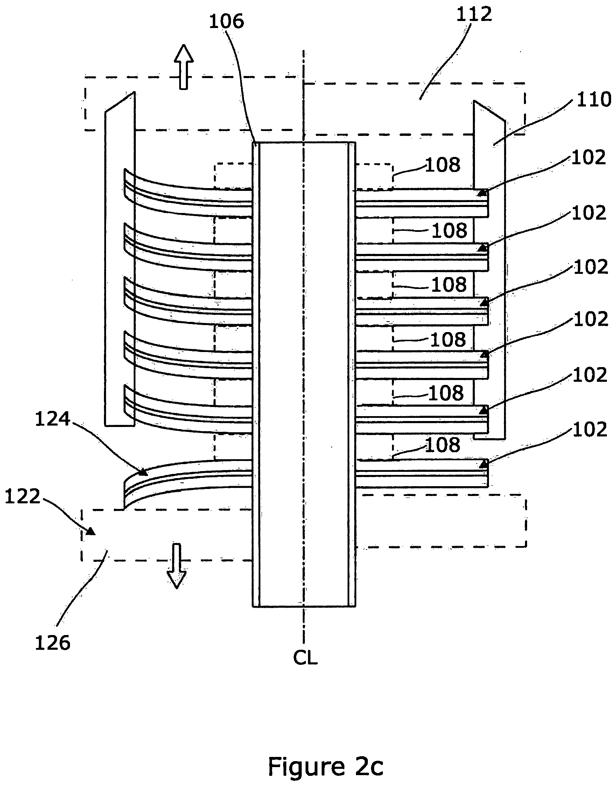

Turning to Figure 2c an embodiment is shown in which a second linkage 122 is connected to a second actor 124 that is arranged to be changed or displaced in a different way to the first actors 102. In this embodiment the second actor 124 is displaced in an opposing direction to the direction of movement of the first actors.

A multiplicity of actors may be used to provide additional functions other than actuation, such as the operation of clutches, friction control devices, mechanical switches, electrical switches, pneumatic switches, force sensing, displacement sensing, rotational speed sensing, motion sensing or energy scavenging. This concept is shown in outline in Figure 2c where moveable component 126 can be displaced independently from linkage 110 and moveable component 112 and if required in the opposing direction in order to perform a separate function which is consistent with operation of the system overall.

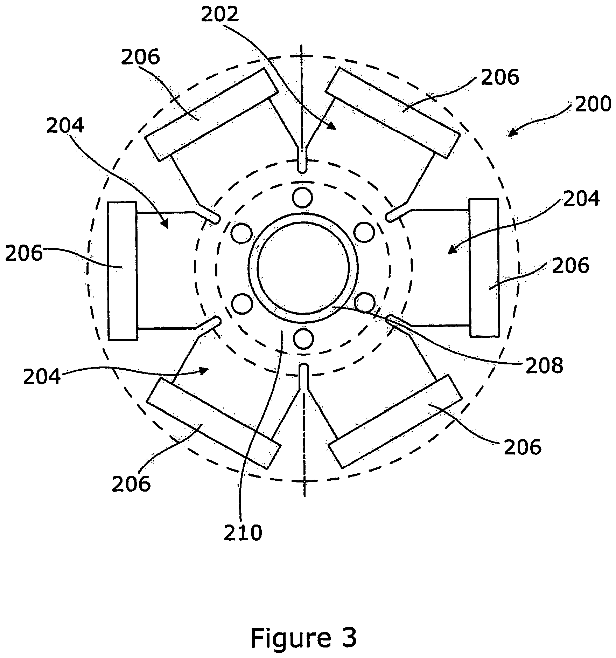

Figure 3 shows a plan view of a composite actuator 200 according to the above description and Figures 2a, b and c. In the actuator of Figure 3 the uppermost bimorph actuator 202 has six actors 204 which can operate either independently or co-operatively. A moveable linkage 206 is shown as having independently moveable segments each of which are linked to a sub-set of actors 204. Alternatively moveable linkage 206 could be represented as a single component linking all of the actors in the actuator. Each of the actors 204 extends outwardly around a central column 208 from a support element 210 surrounding the central column 208.

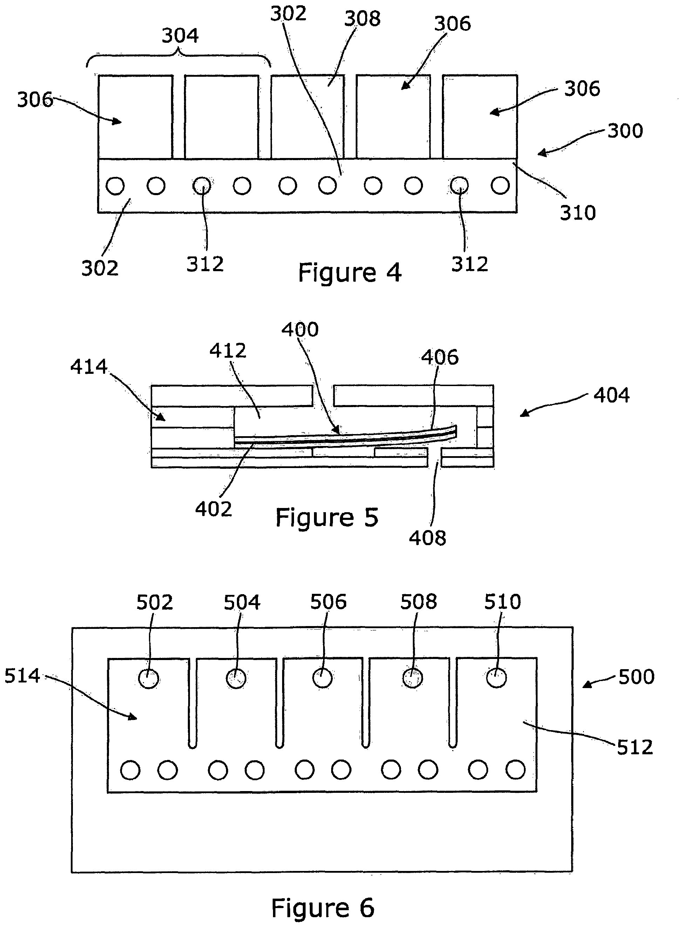

Figure 4 shows an actuator 300 comprising a linear bimorph device 302 according to the present invention that has a linear array 304 of five moveable actors 306. Each actor 306 has on its surface a coating 308 of conductive material on an external surface of a first outer layer of piezoelectric material. The electrically conducting coating is patterned so that it provides a surface electrode for the underlying electro-active piezo electric material 310. The central reinforcement provides mechanical strength and also an electrically conductive layer, such that a voltage can be applied across the electro-active piezoelectric material 310. It should be understood that alternative shaped actuators each with multiple moveable elements can be used as component parts of the invented actuator system. The actors 306 may be operated synchronously or may be controlled to be independently moveable. Openings 312 in the bimorph device 302 are used as conduits for electrical interconnections or optical connections or as a conduit for fluids or for open access or for through access.

Figure 5 shows in cross-section that an actuator 400 in a linear array can be mounted to form a valve 404. The linear array of actors 406 is mounted in such a way as to block an opening 408 in a first position and on activation of the flexible actor 406 of the linear array the actor 406 moves to unblock the opening 408 so that fluids or gases may pass through it. In Figure 5 an opening 408 represents an inlet to a chamber 412 formed from a structural support 414. The structural support 414 is made preferably from a single polymeric moulding, but it may equally be assembled from a number of sub-components. In a variation it can be appreciated that equally opening 408 could act as a controllable opening or valve to allow the passage fluids or gasses into chamber 412.

Figure 6 shows a plan view of a linear valve array 500 where openings 502, 504, 506, 508, 510 may be used as inlets or outlets for an internal chamber 512 such as the chamber 412 in Figure 5. The individual openings 502, 504, 506, 508, 510 may be opened or blocked independently by control of the activation of individual flexible actors 514 of the actuator.

It should be evident therefore that a multiplicity of different fluids or gases or can be introduced controllably to the chamber 512 where they are able to mix together, furthermore fluids or gasses at different temperatures may also be introduced controllably to the chamber 512 and their combined product can be emitted from an outlet or outlets.

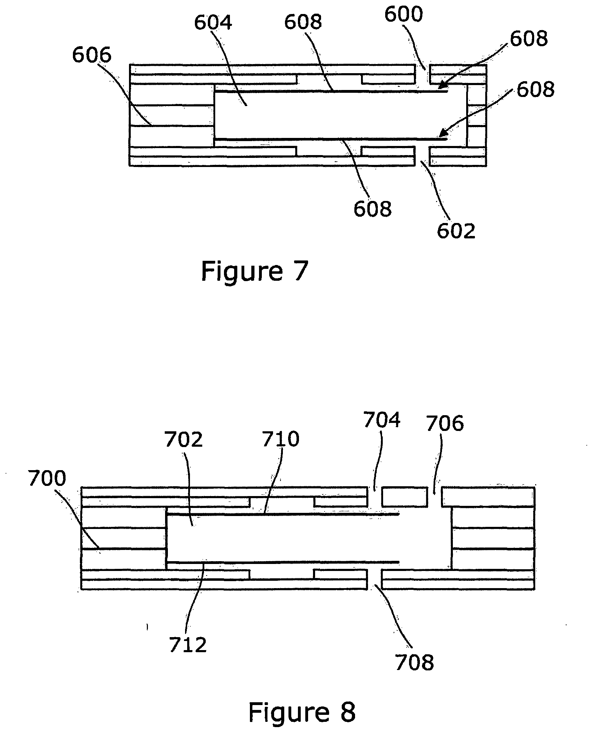

Figure 7 in cross-section shows a further variation whereby both inlets 600 and outlets 602 of a chamber 604 in a valve 606 can be blocked or unblocked by actors 608. In this way opening and closing of each of the inlets and outlets can be controlled either in a pre-defined sequence or independently.

In Figure 8 a variation of a valve 700 is shown whereby the opening and closing of multiple inlets 704 and outlets 708 to a chamber 702 is controllable by actors 710 and 712 in order to achieve mixing of fluids and gasses from different sources and the products of mixing are free to exit from an uncontrolled opening or openings 704. An additional uncontrolled inlet or outlet 706 may be incorporated if desired in a manner that would be well known to a man skilled in the art.

In all of the variations described by Figures 5 to 8 it should be recognised that a subset of actors in a linear array actuator can be used independently to perform a separate function for the fluidic or pneumatic system of which it is part. As an example a subset of actors may be assigned to function as safety valves, or flow sensors, or pressure sensors, or as part of a system of flow regulation, or as part of a system for compositional regulation, or as part of a system of temperature regulation, or as part of an energy scavenging system.

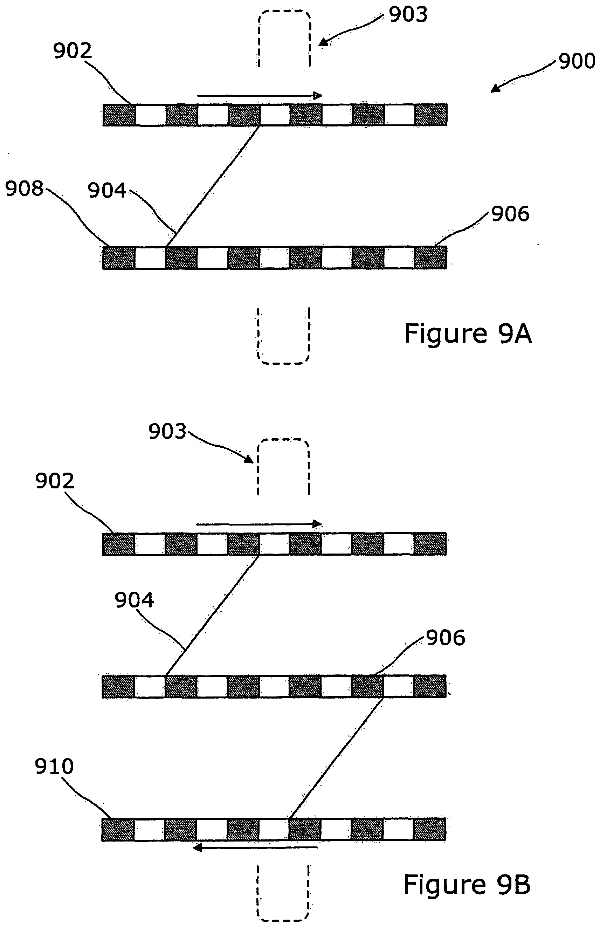

In Figure 9A an embodiment of the invention is described in use in a motor 900, In this example the motor 900 based on an elastic fin drive mechanism. These motors have been known per se for some time and are suitable for miniaturisation. The motor 900 comprises a rotor 902, rotatable about an axle 903, having an elastic fin 904 extending therefrom. The elastic fin is in frictional contact with composite actuator 906 in accordance with an aspect of the invention. The elastic fin and the composite actuator are preloaded with a spring (not shown) to bring them into frictional contact.

As the motor 900 is operated the composite actuator 906 pushes against the fin 904 extending from the rotor 902 and with each push the rotor moves by a small amount. As the composite actuator relaxes and moves away from the rotor the fin slides across a surface 908 of the composite actuator.

In Figure 9B a modified motor is schematically illustrated in which a second rotor 910 is provided opposed to the first rotor 902 and arranged to rotate in an opposite direction. In this embodiment the actuator 906 is arranged to have a subset of actors that are bi-morphs and are able to thrust either up or down and so can rotate either rotor 902 or rotor 910. In addition although not illustrated a separate subset of actors is arranged to operate a mechanical clutch which enables selective switching between the rotors. Such an arrangement has been described in relation to Figure 2. In Figure 2 the composite actuator is driving a mechanical linkage but and this linkage an be brought into contact with the elastic fin drive.

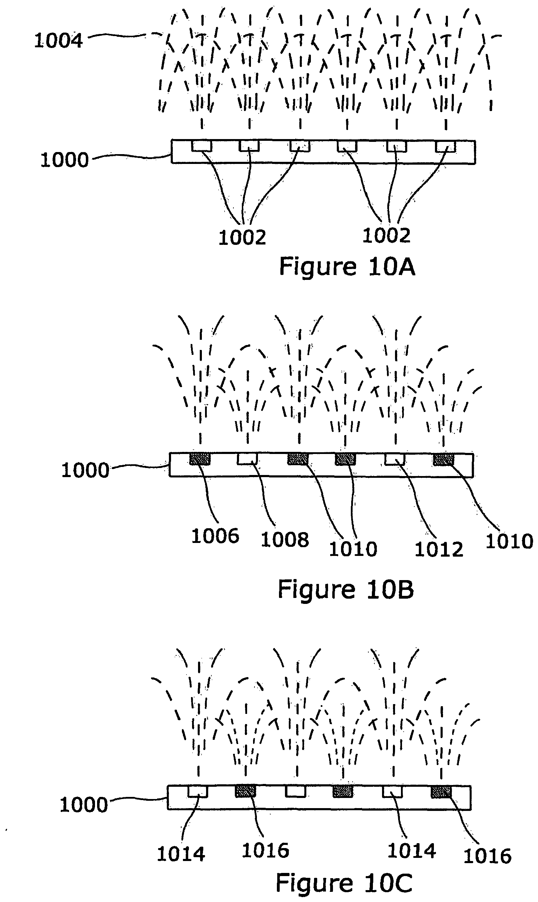

Figure 10A, 10B and 10C are embodiments of the invention used to control the flow of fluids n different situations in which the composite actuator is arranged to control multiple openings in valve arrays.

In Figure 10A a composite actuator 1000 is provided that controls fluid flow from a number of sources 1002. In this embodiment each of the sources of fluid 1002 are at the same temperature and pressure and the jets 1004 of fluid delivered are evenly directed. It is envisaged that such an arrangement can be used in high velocity impingement cooling, in aerodynamic flow control, in raindrop of insect shielding and in functional applications such as raindrop manipulation and demisting.

In Figure 10B a composite actuator 1000 controls fluid flow from a number of sources 1006, 1008, 1010 and 1012 and each of these groups of sources are at different temperatures and/or pressures. Linked groups of actors are arranged to operate each of the groups of sources as required in order to achieve a desired fluid flow. In an alternative embodiment the actors on the composite actuator 1000 are arranged in subsets which are independently controllable so as to control the flow of fluid from each group of sources independently.

In Figure 10C a composite actuator 1000 controls fluid flow from alternative first and second sources 1014 and 1016. In this embodiment the fluid from the first source 1014 is different from the fluid from the second source 1016 and the pressure of the fluid may be different. The composite actuator is arranged to control fluid from the first source 1014 at a first rate and to control fluid flow from the second source to be at a second rate. It is envisaged that these embodiments of the invention may be used to deliver enriched gases, therapies, reagents or fragrances in applications such as personal comfort, healthcare, oxygenation, HVAC system servicing, cleaning and antifouling.

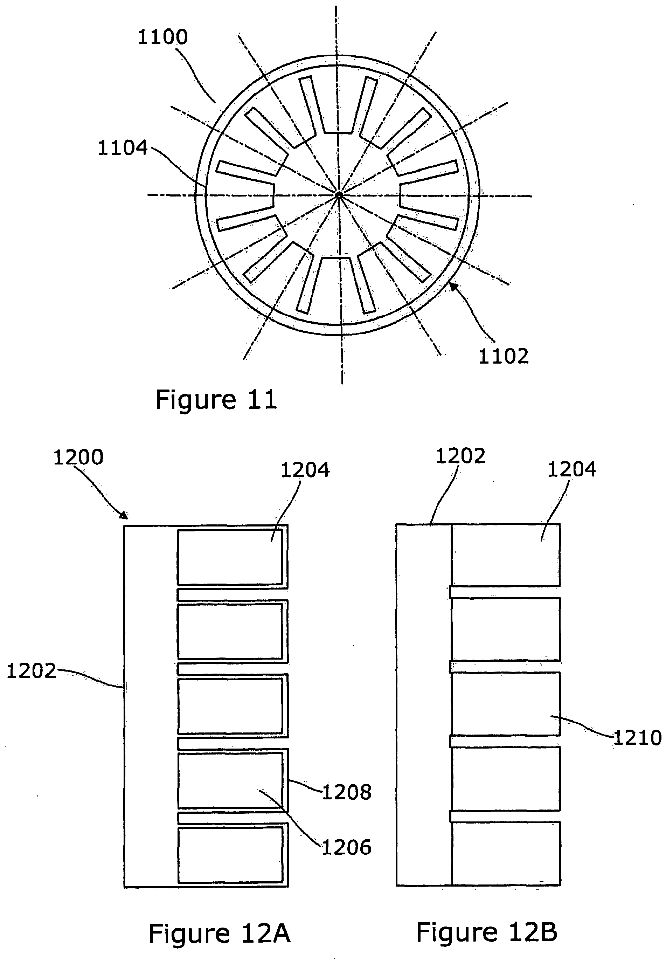

Some modifications to the arrangements of the actuators are now described with reference to Figure 11 and Figure 12. Figure 11 illustrates an arrangement of an actuator 1100 in which a support element 1102 is arranged around a periphery and twelve individual actors 1104 extend radially inwardly from the support element. Each of the actors can be individually controlled and can be either uni-morph or bi morph arrangements. The skilled man will also realise that the support element may be provided with actors extending on either side of the support element and that this can be arranged if the support element is linear or is circular or indeed other forms may be utilised for the support element. It will also be appreciated that the diameter of the radial support element may be increased and that there may be a variable and large number of actuators extending radially inwardly from the peripheral support element. In some cases from 2 to 500 actors or from 50 to 100 actors may be arranged to extend radially from the support element. It is foreseeable that a central support element could be arranged to be in the form of a ring and for a large number such as 2 to 500 or from 50 to 100 actors to extend radially from the support element.

Figure 12 schematically illustrated a variation of a linear actuator 1200 having a support element 1202 and a number of actors 1204 extending therefrom. Figure 12A shows an upper side of the actuator 1202 and the actors 1204 with each actor being formed of a layer of piezoelectric material and Figure 12B shows an underside of the outer layer of piezoelectric material which in use is bonded to the reinforcement layer. On the outer side of the actor the piezoelectric material is provided with an electrically conductive outer coating 1206 which a band 1208 of non conductive material located around a periphery of the actor. In this embodiment the actor is provided with an inner coating 1210 of electrically conductive material on an inner side of the piezoelectric material. The inner coating 1210 is bonded to the reinforcement layer. The inner coating 1210 extends to the periphery of the actor.

It is also possible to reverse this arrangement so that a band of non conductive material 1208 is provided on the inner side of the piezoelectric material and the inner coating 1210 does not extend to the periphery of the actor. An outer coating 1206 can be arranged to extend to the periphery of the actor. It has been found that one of these arrangements is advantageous in that the voltage can be applied to the non exposed face and this can be regarded as a safety feature.

These embodiments have been selected for description to illustrate the invention by way of example and not by way of limitation, the invention being defined by the claims.

## Claims

1. A piezoelectric bending actuator (1; 26; 102; 200; 300; 1200) comprising a support element (6; 28;; 210;) and a plurality of piezo-electric actors (2; 30; 104; 204; 306; 514) having a composite structure: wherein
each piezo-electric actor (2) has at least a first planar outer layer (10) of piezoelectric material bonded to a planar reinforcement layer (14),
an electrically conductive outer coating (18) on an external surface of the first planar outer layer of piezoelectric material, the electrically conductive coating (18; 38; 48; 308) patterned so that it provides a surface electrode for a portion of the electro-active piezo electric material (46; 310) underlying the electrically conductive coating and defining a tongue portion in the plane of the coating
**characterised in that**
each piezo-electric actor (2) is integral with and extends from the support element (6);
the actuator comprises first and second actors which are independently controllable, wherein optionally the first actor (102) is arranged to have a first function and the second actor (124) is arranged to have a second function, and
at least one of the first actors and one of the second actors are each connected to a first linkage (206) arranged to transfer a force or a displacement from the at least one of the first and the at least one of second actors (204).

2. A piezo-electric bending actuator according to claim 1 wherein the actuator, comprising an array of actors, is at least one of radial, linear, curved, or rectilinear.

3. A piezoelectric bending actuator according to claim 1 wherein the actuator (1; 26; 102; 200; 300) comprises at least a first actor having a unimorph structure and at least one second actor having a bimorph structure.

4. A piezoelectric bending actuator (1; 200; 300; 500) according to any one of claims 1 to 3 wherein at least one access port (22; 312) or via is formed wherein the access port or via facilitates communication with at least one reinforcement layer and wherein the port or via (22; 312) provides
i) a fluidic channel or
ii) an optical access route or iii) wherein the via can be utilised by at least one ancillary component selected from a group comprising ancillary mechanical components, electrical components, tubes, pressurised tubes, fibre optics or structural components.

5. A piezoelectric bending actuator (1) according to claim 1 wherein the or each actor (2) comprises the first planar outer layer (10; 34) and a second outer layer (12; 44) of piezoelectric material bonded to the planar reinforcement layer (14; 40) and wherein
the outer layer (10; 12) has an inner coating of an electrically conductive material on an inner surface facing the intermediate reinforcement layer and wherein the electrically conductive coating may be formed of chromium, gold, platinum, titanium, aluminium or their alloys or carbon or organic carbon derivatives and one or both of the electrically conductive outer coating and electrically conductive inner coating is provided with a band of non-conductive material around a periphery and the band has a width of from 1 to 1000 µm or more preferably from 5 to 500 µm and most preferably from 10 to 250 µm.

6. A composite bending actuator (100) comprising at least a first and a second piezo-electric actuator (102) according to any one of claims 1 to 5.

7. A composite piezoelectric bending actuator according to claim 6 wherein at least a first actor of the first actuator and a first actor of the second actuator are each connected to the first linkage (110) arranged to transfer a force or a displacement from the first and the second actuator when a voltage is applied to the respective first actors, and wherein each first actor connected to the first linkage is electrically linked in parallel such that each of the first actors can be driven synchronously from an electrical signal.

8. A composite piezoelectric bending actuator according to claim 6 wherein a first actor of the first actuator and a first actor of the second actuator are each connected to a first linkage (110) arranged to transfer a force or a displacement from the first and the second actuator when a voltage is applied to the respective first actors, and:
at least one second actor is connected to a second linkage and the second linkage (122) is arranged to transfer a force and/or displacement of the at least one second actor in a direction differing from a direction of displacement of the first linkage.

9. A composite piezoelectric bending actuator according to claim 8 wherein the first linkage (110) is arranged to drive a mechanical component (112) in a first direction and the second linkage (122) is arranged to drive a second mechanical component (126) in a second direction and
the first mechanical component (112) moves in the first direction and the second mechanical component (126) moves in the reverse direction such that bidirectional rotation is produced;
and optionally wherein the composite actuator has a length of from 1.0 mm to 50 mm and/or diameter from 1 mm to 100 mm.

10. A composite bending actuator (100) according to claim 8 wherein the actuator comprises at least the first actor connected to the first linkage (110) arranged to drive a mechanical component (112) in a first direction and the at least second actor (124) is connected to the second linkage (122) to operate another mechanism such as a clutch mechanism or a brake mechanism and optionally wherein the composite actuator (100) operates to move a mechanism into frictional contact with a further composite actuator.

11. A composite bending actuator (100) according to claim 6 wherein the actuator comprises at least one actor arranged to generate a force or movement, by means of the converse piezoelectric effect, in a first direction in response to a voltage applied to the actuator and at least one second actor is arranged to sense an applied force using the direct piezoelectric effect or
wherein at least one actor moves to generate an electrical charge from the application of an external mechanical force, such an electrical charge preferably providing a signal to a sensing system, or supplying the electrical charge being supplied to an energy scavenging system, or an energy storage system.

12. A device (404; 500; 700; 900) containing a piezo-electric actuator according to any one of claims 1 to 5 or a composite piezo-electric bending actuator according to any one of claims 6 to 11 wherein the device is selected from the group comprising: a motor (900), a surgical instrument, a drug delivery system, a motorised articulating mechanical joint, a pneumatic or fluidic valve.

13. A device containing a composite piezo-electric bending actuator according to claim 10 wherein the device comprises an integral clutch or brake mechanism and the composite actuator comprises a first linkage arranged to drive a mechanical component in a first direction; a second linkage is arranged to drive a second mechanical component in a second direction and the first mechanical component moves in a first direction and the second mechanical component moves in a reverse direction such that bidirectional rotation is produced and a third linkage is arranged to operate a third mechanism, such as a clutch or brake mechanism.

14. A pneumatic or fluidic valve (404; 500) comprising
i) one or more piezo-electric actuators according to any one of claims 1 to 5 or composite piezo-electric bending actuators in accordance with claim 6 to 11 wherein the first actor or actors (400; 514) control at least one fluidic channel, inlet or outlet in a linear valve array wherein optionally the first actor or actors control at least a second fluidic channel, inlet or outlet in the linear valve array or
ii) comprising a plurality of composite piezo-electric bending actuators in accordance with any one of claims 6 to 11 and wherein a sub set comprising at least one actuator or composite actuator is arranged to control fluid flow and optionally the subset is arranged to control fluid flow in a valve or in a linear valve array or
iii) wherein the valve is arranged to control a flow of fluid from at least one pressured source (1002; 1006; 1008; 1010; 1012; 1014; 1016) through at least one outlet and preferably there are two or more sources (1014; 1016) and two or more outlets and wherein optionally the two or more sources may be the same or different fluids and may be at the same or different temperatures and/or pressures and optionally the pneumatic or fluidic valve comprises a valve array and optionally the valve array is selected from the group comprising linear, circular and curved arrays or bi linear or tri-linear arrays.

15. Use of a pneumatic or fluidic valve according to claim 14 to control flow from at least one pressurised source wherein preferably the valve is arranged to control a fluid flow from two or more sources (1014; 1016) and wherein each source may be at the same temperature and/or pressure or may be at a different temperature and/or pressure and optionally the pressurised source is used for one of impingement cooling, raindrop shielding, insect shielding, automotive aerodynamic flow control, surface demisting, thermal regulation systems, ventilation systems, air stream shaping systems, heating or cooling of vehicle components, fragrance delivery systems providing gaseous mixtures such as oxygen enriched air, or for medical usage such as delivery of drugs, therapies and contrast agents.

## Patentansprüche

1. Piezoelektrischer Biegeaktuator (1; 26; 102; 200; 300; 1200), umfassend ein Trägerelement (6; 28; 210;) und eine Mehrzahl von piezoelektrischen Aktoren (2; 30; 104; 204; 306; 514) mit einer Verbundstruktur; wobei
jeder piezoelektrische Aktor (2) zumindest eine erste ebene Außenschicht (10) aus piezoelektrischem Material hat, die an eine ebene Verstärkungsschicht (14) gebunden ist,
eine elektrisch leitfähige Außenbeschichtung (18) an einer externen Fläche der ersten ebenen Außenschicht aus piezoelektrischem Material, wobei die elektrisch leitfähige Beschichtung (18; 38; 48; 308) gemustert ist, sodass sie eine Oberflächenelektrode für einen Abschnitt des elektroaktiven piezoelektrischen Materials (46; 310) bereitstellt, das unter der elektrisch leitfähigen Beschichtung liegt, und in der Ebene der Beschichtung einen Zungenabschnitt definiert,
**dadurch gekennzeichnet, dass**
jeder piezoelektrische Aktor (2) mit dem Trägerelement (6) einstückig ist und sich davon erstreckt;
der Aktuator erste und zweite Aktoren umfasst, die unabhängig steuerbar sind, wobei optional der erste Aktor (102) dafür angeordnet ist, eine erste Funktion zu haben, und der zweite Aktor (124) dafür angeordnet ist, eine zweite Funktion zu haben, und mindestens einer der ersten Aktoren und einer der zweiten Aktoren jeweils mit einer ersten Verbindung (206) verbunden sind, die zum Übertragen einer Kraft oder einer Verschiebung von dem mindestens einem der ersten und dem mindestens einen der zweiten Aktoren (204) angeordnet ist.

2. Piezoelektrischer Biegeaktuator nach Anspruch 1, wobei der Aktuator, der eine Anordnung von Aktoren umfasst, mindestens eines von radial, linear, gekrümmt oder geradlinig ist.

3. Piezoelektrischer Biegeaktuator nach Anspruch 1, wobei der Aktuator (1; 26; 102; 200; 300) mindestens einen ersten Aktor mit einer Unimorph-Struktur und mindestens einen zweiten Aktor mit einer Bimorph-Struktur umfasst.

4. Piezoelektrischer Biegeaktuator (1; 200; 300; 500) nach einem der Ansprüche 1 bis 3, wobei mindestens ein Zugangsanschluss (22; 312) oder eine Durchkontaktierung gebildet ist, wobei der Zugangsanschluss oder die Durchkontaktierung die Verbindung mit mindestens einer Verstärkungsschicht ermöglicht und wobei der Anschuss oder die Durchkontaktierung (22; 312) bereitstellt:
i) einen Fluidkanal oder
ii) eine optische Zugangsroute oder
iii) wobei die Durchkontaktierung von mindestens einer Nebenkomponente genutzt werden kann, die ausgewählt ist aus der Gruppe umfassend mechanische Nebenkomponenten, elektrische Komponenten, Schläuche, Druckschläuche, Lichtleitfasern oder strukturelle Komponenten.

5. Piezoelektrischer Biegeaktuator (1) nach Anspruch 1, wobei der oder jeder Aktor (2) die erste ebene Außenschicht (10; 34) und eine zweite Außenschicht (12; 44) aus piezoelektrischem Material umfasst, die an die ebene Verstärkungsschicht (14; 40) gebunden sind, und wobei
die Außenschicht (10; 12) eine Innenbeschichtung aus einem elektrisch leitfähigen Material an einer Innenfläche hat, die der zwischenliegenden Verstärkungsschicht zugewandt ist, und wobei die elektrisch leitfähige Beschichtung aus Chrom, Gold, Platin, Titan, Aluminium oder deren Legierungen oder Kohlenstoff oder organischen Kohlenstoffderivaten gebildet sein kann und eine oder beide der elektrisch leitfähigen Außenbeschichtung und der elektrisch leitfähigen Innenbeschichtung mit einem Streifen aus einem nicht leitfähigen Material um eine Peripherie versehen sind und der Streifen eine Breite von 1 bis 1000 µm oder bevorzugter von 5 bis 500 µm und besonders bevorzugt von 10 bis 250 µm hat.

6. Verbund-Biegeaktuator (100), umfassend zumindest einen ersten und einen zweiten piezoelektrischen Aktuator (102) nach einem der Ansprüche 1 bis 5.

7. Piezoelektrischer Verbund-Biegeaktuator nach Anspruch 6, wobei zumindest ein erster Aktor des ersten Aktuators und ein erster Aktor des zweiten Aktuators jeweils mit der ersten Verbindung (110) verbunden sind, die zum Übertragen einer Kraft oder einer Verschiebung vom ersten und vom zweiten Aktuator angeordnet ist, wenn eine Spannung an die jeweiligen ersten Aktoren angelegt wird, und wobei jeder erste Aktor, der mit der ersten Verbindung verbunden ist, parallel elektrisch verbunden ist, sodass jeder der ersten Aktoren synchron von einem elektrischen Signal angetrieben werden kann.

8. Piezoelektrischer Verbund-Biegeaktuator nach Anspruch 6, wobei
ein erster Aktor des ersten Aktuators und ein erster Aktor des zweiten Aktuators jeweils mit einer ersten Verbindung (110) verbunden sind, die zum Übertragen einer Kraft oder einer Verschiebung vom ersten und vom zweiten Aktuator angeordnet ist, wenn eine Spannung an die jeweiligen ersten Aktoren angelegt wird, und:
mindestens ein zweiter Aktor mit einer zweiten Verbindung verbunden ist und die zweite Verbindung (122) zum Übertragen einer Kraft und/oder Verschiebung des mindestens einen zweiten Aktors in einer Richtung angeordnet ist, die sich von einer Verschiebungsrichtung der ersten Verbindung unterscheidet.

9. Piezoelektrischer Verbund-Biegeaktuator nach Anspruch 8, wobei die erste Verbindung (110) zum Antreiben einer mechanischen Komponente (112) in einer ersten Richtung angeordnet ist und die zweite Verbindung (122) zum Antreiben einer zweiten mechanischen Komponente (126) in einer zweiten Richtung angeordnet ist, und
die erste mechanische Komponente (112) sich in der ersten Richtung bewegt und die zweite mechanische Komponente (126) sich in der umgekehrten Richtung bewegt, sodass eine bidirektionale Drehung erzeugt wird;
und wobei der Verbund-Aktuator optional eine Länge von 1,0 mm bis 50 mm und/oder einen Durchmesser von 1 mm bis 100 mm hat.

10. Verbund-Biegeaktuator (100) nach Anspruch 8, wobei der Aktuator zumindest umfasst, dass der erste Aktor mit der ersten Verbindung (110) verbunden ist, die zum Antreiben einer mechanischen Komponente (112) in einer ersten Richtung angeordnet ist, und der zumindest zweite Aktor (124) mit der zweiten Verbindung (122) verbunden ist, um einen anderen Mechanismus wie einen Kupplungsmechanismus oder einen Bremsmechanismus zu betreiben, und wobei der Verbund-Aktuator (100) optional betrieben wird, um einen Mechanismus in Reibungskontakt mit einem weiteren Verbund-Aktuator zu bewegen.

11. Verbund-Biegeaktuator (100) nach Anspruch 6, wobei der Aktuator mindestens einen Aktor umfasst, der zum Erzeugen einer Kraft oder Bewegung, mittels des umgekehrten piezoelektrischen Effekts, in einer ersten Richtung als Reaktion auf eine an den Aktuator angelegte Spannung angeordnet ist, und mindestens ein zweiter Aktor zum Erfassen einer aufgebrachten Kraft mittels des direkten piezoelektrischen Effekts angeordnet ist, oder
wobei sich mindestens ein Aktor zum Erzeugen einer elektrischen Ladung aus der Aufbringung einer externen mechanischen Kraft bewegt, wobei eine solche elektrische Ladung vorzugsweise ein Signal für ein Erfassungssystem bereitstellt oder die elektrische Ladung bereitstellt, die einem Energy-Harvesting-System oder einem Energiespeichersystem zugeführt wird.

12. Vorrichtung (404; 500; 700; 900), die einen piezoelektrischen Aktuator nach einem der Ansprüche 1 bis 5 oder einen piezoelektrischen Verbund-Biegeaktuator nach einem der Ansprüche 6 bis 11 enthält, wobei die Vorrichtung ausgewählt ist aus der Gruppe umfassend: einen Elektromotor (900), ein chirurgisches Instrument, ein Arzneimittelabgabesystem, ein motorisiert bewegliches mechanisches Gelenk, ein pneumatisches oder strömungsmechanisches Ventil.

13. Vorrichtung, die einen piezoelektrischen Verbund-Biegeaktuator nach Anspruch 10 enthält, wobei die Vorrichtung einen integralen Kupplungs- oder Bremsmechanismus umfasst und der Verbund-Aktuator eine erste Verbindung umfasst, die zum Antreiben einer mechanischen Komponente in einer ersten Richtung angeordnet ist; eine zweite Verbindung ist zum Antreiben einer zweiten mechanischen Komponente in einer zweiten Richtung angeordnet, und die erste mechanische Komponente bewegt sich in einer ersten Richtung und die zweite mechanische Komponente bewegt sich in einer umgekehrten Richtung, sodass eine bidirektionale Drehung erzeugt wird, und eine dritte Verbindung ist zum Betreiben eines dritten Mechanismus angeordnet, z. B. eines Kupplungs- oder Bremsmechanismus.

14. Pneumatisches oder strömungsmechanisches Ventil (404; 500), umfassend
i) einen oder mehrere piezoelektrische Aktuatoren nach einem der Ansprüche 1 bis 5 oder piezoelektrische Verbund-Biegeaktuatoren in Übereinstimmung mit Anspruch 6 bis 11, wobei der erste Aktor oder die ersten Aktoren (400; 514) mindestens einen Fluidkanal, -einlass oder -auslass in einer linearen Ventilanordnung steuern, wobei der erste Aktor oder die ersten Aktoren optional mindestens einen zweiten Fluidkanal, -einlass oder -auslass in der linearen Ventilanordnung steuern, oder
ii) umfassend eine Mehrzahl von piezoelektrischen Verbund-Biegeaktuatoren in Übereinstimmung mit einem der Ansprüche 6 bis 11 und wobei eine Teilmenge, die mindestens einen Aktuator oder Verbund-Aktuator umfasst, zum Steuern einer Fluidströmung angeordnet ist und die Teilmenge optional zum Steuern der Fluidströmung in einem Ventil oder in einer linearen Ventilanordnung angeordnet ist, oder
iii) wobei das Ventil zum Steuern einer Strömung eines Fluids von mindestens einer Druckquelle (1002; 1006; 1008; 1010; 1012; 1014; 1016) durch mindestens einen Auslass angeordnet ist und bevorzugt zwei oder mehr Quellen (1014; 1016) und zwei oder mehr Auslässe vorhanden sind, und wobei die zwei oder mehr Quellen optional dasselbe oder unterschiedliche Fluide sein können und dieselbe oder eine unterschiedliche Temperatur und/oder denselben oder einen unterschiedlichen Druck haben können, und wobei das pneumatische oder strömungsmechanische Ventil optional eine Ventilanordnung umfasst und die Ventilanordnung optional aus der Gruppe ausgewählt ist, die lineare, kreisförmige und gekrümmte Anordnungen oder bilineare oder trilineare Anordnungen umfasst.

15. Verwendung eines pneumatischen oder strömungsmechanischen Ventils nach Anspruch 14 zum Steuern einer Strömung von mindestens einer Druckquelle, wobei das Ventil bevorzugt zum Steuern einer Fluidströmung von zwei oder mehr Quellen (1014; 1016) angeordnet ist und wobei jede Quelle dieselbe Temperatur und/oder denselben Druck haben kann oder eine unterschiedliche Temperatur und/oder einen unterschiedlichen Druck haben kann, und wobei die Druckquelle optional verwendet wird für eines von Prallkühlung, Regenschutz, Insektenschutz, aerodynamische Strömungssteuerung von Automobilen, Entnebelung von Oberflächen, Wärmereguliersysteme, Belüftungssysteme, Systeme zur Luftstromformung, Beheizung oder Kühlung von Fahrzeugkomponenten, Riechstoffabgabesysteme, die gasförmige Gemische wie sauerstoffangereicherte Luft bereitstellen, oder für die medizinische Nutzung, beispielsweise die Abgabe von Arzneimitteln, Therapien und Kontrastmittel.

## Revendications

1. Actionneur à flexion piézoélectrique (1; 26; 1O2 ; 200; 300; 1200) comprenant un élément de support (6 ; 28 ; 210 ;) et une pluralité de déclencheurs piézoélectriques (2 ; 30 ; 104 ; 204 ; 306 ; 514) comportant une structure composite : dans lequel
chaque déclencheur piézoélectrique (2) comporte au moins une première couche extérieure plane (10) de matériau piézoélectrique liée à une couche de renfort plane (14),
un revêtement extérieur électriquement conducteur (18) sur une surface externe de la première couche extérieure plane de matériau piézoélectrique, le revêtement électriquement conducteur (18 ; 38 ; 48 ; 308) étant structuré de manière à fournir une électrode de surface pour une portion du matériau piézoélectrique électro-actif (46 ; 310) au-dessous du revêtement électriquement conducteur et définissant une portion de langue dans le plan du revêtement,
**caractérisé en ce que**
chaque déclencheur piézoélectrique (2) fait partie intégrante de l'élément de support (6) et s'étend depuis ce dernier ;
l'actionneur comprend des premier et deuxième déclencheurs qui peuvent être commandés indépendamment, dans lequel facultativement le premier déclencheur (102) est agencé pour avoir une première fonction et le deuxième déclencheur (124) est agencé pour avoir une deuxième fonction, et au moins l'un des premiers déclencheurs et au moins l'un des deuxièmes déclencheurs sont chacun raccordés à une première liaison (206) agencée pour transférer une force ou un déplacement depuis l'au moins un des premiers déclencheurs et l'au moins un des deuxièmes déclencheurs (204).

2. Actionneur à flexion piézoélectrique selon la revendication 1, dans lequel l'actionneur, comprenant un réseau de déclencheurs, est au moins l'un de radial, linéaire, incurvé ou rectiligne.

3. Actionneur à flexion piézoélectrique selon la revendication 1, dans lequel l'actionneur (1; 26; 102; 200; 300) comprend au moins un premier déclencheur comportant une structure unimorphe et au moins un deuxième déclencheur comportant une structure bimorphe.

4. Actionneur à flexion piézoélectrique (1; 200; 300; 500) selon l'une quelconque des revendications 1 à 3, dans lequel au moins un orifice d'accès (22 ; 312) ou un passage est formé, dans lequel l'orifice d'accès ou le passage facilite une communication avec au moins une couche de renfort, et dans lequel l'orifice ou le passage (22 ; 312) fournit :
i) un canal fluidique, ou
ii) un itinéraire d'accès optique, ou
iii) dans lequel le passage peut être utilisé par au moins un composant auxiliaire sélectionné dans un groupe comprenant des composants mécaniques auxiliaires, des composants électriques, des tubes, des tubes pressurisés, des fibres optiques ou des composants structurels.

5. Actionneur à flexion piézoélectrique (1) selon la revendication 1, dans lequel le déclencheur ou chaque déclencheur (2) comprend la première couche extérieure plane (10 ; 34) et une deuxième couche extérieure (12 ; 44) de matériau piézo-électrique liée à la couche de renfort plane (14 ; 40), et dans lequel
la couche extérieure (10; 12) comporte un revêtement intérieur d'un matériau électriquement conducteur sur une surface intérieure faisant face à la couche de renfort intermédiaire et dans lequel le revêtement électriquement conducteur peut être constitué de chrome, d'or, de platine, de titane, d'aluminium ou de leurs alliages ou de dérivés de carbone ou de carbone organique, et l'un ou les deux du revêtement extérieur électriquement conducteur et du revêtement intérieur électriquement conducteur sont pourvus d'une bande de matériau non conducteur autour d'une périphérie, la bande présentant une largeur de 1 à 1000 µm, de préférence de 5 à 500 µm, et avec le plus de préférence de 10 à 250 µm.

6. Actionneur à flexion composite (100) comprenant au moins un premier et un deuxième actionneur piézoélectrique (102) selon l'une quelconque des revendications 1 à 5.

7. Actionneur à flexion piézoélectrique composite selon la revendication 6, dans lequel au moins un premier déclencheur du premier actionneur et un premier déclencheur du deuxième actionneur sont chacun raccordés à la première liaison (110) agencée pour transférer une force ou un déplacement depuis le premier actionneur et le deuxième actionneur lorsqu'une tension est appliquée aux premiers déclencheurs respectifs, et dans lequel chaque premier déclencheur raccordé à la première liaison est électriquement relié en parallèle de sorte que chacun des premiers déclencheurs puisse être commandé de manière synchrone depuis un signal électrique.

8. Actionneur à flexion piézoélectrique composite selon la revendication 6, dans lequel un premier déclencheur du premier actionneur et un premier déclencheur du deuxième actionneur sont chacun raccordés à une première liaison (110) agencée pour transférer une force ou un déplacement depuis le premier et le deuxième actionneur lorsqu'une tension est appliquée aux premiers déclencheurs respectifs ; et
au moins un deuxième déclencheur est raccordé à une deuxième liaison et la deuxième liaison (122) est agencée pour transférer une force et/ou un déplacement de l'au moins un deuxième déclencheur dans un sens différent d'un sens de déplacement de la première liaison.

9. Actionneur à flexion piézoélectrique composite selon la revendication 8, dans lequel la première liaison (110) est agencée pour entraîner un composant mécanique (112) dans un premier sens et la deuxième liaison (122) est agencée pour entraîner un deuxième composant mécanique (126) dans un deuxième sens, et
le premier composant mécanique (112) se déplace dans le premier sens et le deuxième composant mécanique (126) se déplace dans le sens inverse de manière à produire une rotation bidirectionnelle ;
et facultativement dans lequel l'actionneur composite présente une longueur de 1,0 mm à 50 mm et/ou un diamètre de 1 mm à 100 mm.

10. Actionneur à flexion composite (100) selon la revendication 8, dans lequel l'actionneur comprend au moins le premier déclencheur raccordé à la première liaison (110) agencée pour entraîner un composant mécanique (112) dans un premier sens et au moins le deuxième déclencheur (124) est raccordé à la deuxième liaison (122) pour faire fonctionner un autre mécanisme comme un mécanisme d'embrayage ou un mécanisme de frein, et facultativement dans lequel l'actionneur composite (100) fonctionne pour déplacer un mécanisme en contact de friction avec un autre actionneur composite.

11. Actionneur à flexion composite (100) selon la revendication 6, dans lequel l'actionneur comprend au moins un déclencheur agencé pour générer une force ou un mouvement, au moyen de l'effet piézoélectrique inverse, dans un premier sens en réponse à une tension appliquée à l'actionneur, et au moins un deuxième déclencheur est agencé pour détecter une force appliquée en utilisant l'effet piézo-électrique direct, ou
dans lequel au moins un déclencheur se déplace pour générer une charge électrique à partir de l'application d'une force mécanique externe, comme une charge électrique fournissant de préférence un signal à un système de détection, ou alimentant la charge électrique qui est alimentée dans un système de récupération d'énergie, ou dans un système de stockage d'énergie.

12. Dispositif (404; 500; 700; 900) contenant un actionneur piézoélectrique selon l'une quelconque des revendications 1 à 5 ou un actionneur à flexion piézoélectrique composite selon l'une quelconque des revendications 6 à 11, dans lequel le dispositif est sélectionné dans le groupe comprenant : un moteur (900), un instrument chirurgical, un système de distribution de médicaments, une articulation mécanique motorisée, une vanne pneumatique ou fluidique.

13. Dispositif contenant un actionneur à flexion piézoélectrique composite selon la revendication 10, dans lequel le dispositif comprend un mécanisme d'embrayage ou de frein intégral et l'actionneur composite comprend une première liaison agencée pour entraîner un composant mécanique dans un premier sens; une deuxième liaison est agencée pour entraîner un deuxième composant mécanique dans un deuxième sens ; le premier composant mécanique se déplace dans un premier sens et le deuxième composant mécanique se déplace dans un sens inverse de manière à produire une rotation bidirectionnelle ; et une troisième liaison est agencée pour faire fonctionner un troisième mécanisme, comme un mécanisme d'embrayage ou de frein.

14. Vanne pneumatique ou fluidique (404 ; 500) comprenant
i) un ou plusieurs actionneurs piézoélectriques selon l'une quelconque des revendications 1 à 5 ou actionneurs à flexion piézoélectriques composites selon l'une quelconque des revendications 6 à 11, dans laquelle le premier déclencheur ou les premiers déclencheurs (400 ; 514) commandent une entrée ou une sortie d'au moins un canal fluidique dans un réseau de vannes linéaire, dans lequel facultativement le premier déclencheur ou les premiers déclencheurs commandent une entrée ou une sortie d'au moins un deuxième canal fluidique dans le réseau de vannes linéaire, ou
ii) comprenant une pluralité d'actionneurs à flexion piézoélectriques composites selon l'une quelconque des revendications 6 à 11 et dans lequel un sous-ensemble comprenant au moins un actionneur ou un actionneur composite est agencé pour commander un écoulement de fluide et facultativement le sous-ensemble est agencé pour commander un écoulement de fluide dans une vanne ou dans un réseau de vannes linéaire, ou
iii) dans lequel la vanne est agencée pour commander un écoulement de fluide depuis au moins une source pressurisée (1002 ; 1006 ; 1008 ; 1010 ; 1012 ; 1014 ; 1016) à travers au moins une sortie et de préférence il y a au moins deux sources (1014 ; 1016) et au moins deux sorties, dans lequel facultativement les au moins deux sources peuvent être des fluides identiques ou différents et peuvent être à des températures et/ou des pressions identiques ou différentes, et facultativement la vanne pneumatique ou fluidique comprend un réseau de vannes, le réseau de vannes étant facultativement sélectionné dans le groupe se composant de réseaux linéaires, circulaires et incurvés ou de réseaux bilinéaires ou trilinéaires.

15. Utilisation d'une vanne pneumatique ou fluidique selon la revendication 14 pour commander un écoulement depuis au moins une source pressurisée, dans laquelle de préférence la vanne est agencée pour commander un écoulement de fluide depuis au moins deux sources (1014 ; 1016) et dans laquelle chaque source peut être à la même température et/ou à la même pression ou peut être à une température différente et/ou à une pression différente, et facultativement la source pressurisée est utilisée pour l'un d'un refroidissement par impact, d'une protection contre les gouttes de pluie, d'une protection contre les insectes, d'une régulation de flux aérodynamique automobile, d'un désembuage de surface, de systèmes de régulation thermique, de systèmes de ventilation, de systèmes de mise en forme de flux d'air, de chauffage ou de refroidissement de composants de véhicule, de systèmes de diffusion de parfum, d'une fourniture de mélanges gazeux comme de l'air enrichi en oxygène ou pour un usage médical comme la distribution de médicaments, des thérapies et des agents de contraste.
